# FASCICULE DE BREVET EUROPEEN

(11) **EP 1 664 367 B1**
(45) Date de publication et mention de la délivrance du brevet: **12.11.2008**
(21) Numéro de dépôt: 04787278.3
(22) Date de dépôt: 01.09.2004
(51) Int. Cl.: C23C 14/12, C23C 14/02

(54) **PROCEDE DE REALISATION D UN TRAITEMENT ANTI-REFLETS SUR UN SUBSTRAT OPTIQUE, SUBSTRAT OPTIQUE OBTENU PAR CE PROCEDE ET DISPOSITIF DE MISE EN OEUVRE DU PROCEDE**
VERFAHREN ZUR BEHANDLUNG VON ANTIREFLEXIONSBECSHICHTUNGEN AUF EINEM OPTISCHEN SUBSTRAT, SO ERHALTENES OPTISCHES SUBSTRAT UND VORRICHTUNG ZUR DURCHFÜHRUNG DES VERFAHRENS
METHOD FOR TREATING ANTIREFLECTION COATINGS ON AN OPTICAL SUBSTRATE, THE THUS OBTAINED OPTICAL SUBSTRATE AND DEVICE FOR CARRYING GOUT SAID METHOD

(30) Priorité: 04.09.2003 FR 0310473
(43) Date de publication de la demande: 07.06.2006
(73) Titulaire: ESSILOR INTERNATIONAL (Compagnie Générale d'Optique), F-94220 Charenton-le-Pont (FR)
(72) Inventeur: SCHERER, Karin, F-94100 St Maur des Fosses (FR); LACAN, Pascale, F-75011 Paris (FR); BOSMANS, Richard, F-94880 Noiseau (FR)
(74) Mandataire: Kurtz, Laurent Charles Edmond
(86) Numéro de dépôt international: PCT/FR2004/002222
(87) Numéro de publication internationale: WO 2005/024087

(56) Documents cités:
- EP-A- 1 306 695
- WO-A-96/21748
- WO-A-03/056366
- US-A- 5 882 773
- US-B1- 6 235 383
- CHOW R ET AL: "OPTICAL MULTILAYER FILMS BASED ON AN AMORPHOUS FLUOROPOLYMER" JOURNAL OF VACUUM SCIENCE AND TECHNOLOGY: PART A, AMERICAN INSTITUTE OF PHYSICS. NEW YORK, US, vol. 14, no. 1, 1996, pages 63-68, XP000555452 ISSN: 0734-2101 cité dans la demande

## Description

La présente invention a pour objet un procédé de réalisation d'un traitement anti-reflets sur un substrat optique, en particulier une lentille ophtalmique, par dépôt physique en phase gazeuse (PVD) sous vide d'au moins une couche anti-reflets comprenant un polymère fluoré.

Traditionnellement, les traitements anti-reflets consistent en une monocouche de matériau à bas indice de réfraction, et, plus fréquemment, en une alternance de couches minces diélectriques à haut et bas indices de réfraction.

Il convient de relever, à cet égard, que l'obtention d'un très bas indice de réfraction s'avère particulièrement intéressant pour une production à grande échelle telle qu'elle est pratiquée dans le cas des verres ou lentilles ophtalmiques, car il est préférable de limiter le nombre de couches de l'empilement, afin de minimiser le temps de cycle du procédé et ainsi respecter les exigences industrielles en termes de coût et de service. Dans ce contexte, accroître l'écart d'indice entre les couches haut et bas indice, soit en augmentant le haut indice, soit en diminuant le bas indice, permet d'améliorer l'efficacité des traitements anti-reflets tout en conservant un nombre de couches restreint.

A côté des propriétés optiques fonctionnelles, comme par exemple un bas niveau de réflexion et une parfaite transparence dans toute la gamme spectrale visible ou une faible sensibilité de la couleur résiduelle en fonction de l'angle d'observation, le défi majeur pour le développement des empilements anti-reflets sur une lentille ophtalmique est la durabilité des lentilles ophtalmiques traitées face aux agressions de la vie quotidienne. Ainsi, pendant une utilisation courante de deux ans, une lentille sera nettoyée en moyenne un millier de fois, avec des chiffons plus ou moins adaptés, à sec ou en utilisant de l'eau et des lessives. Afin de supporter ces agressions sans préjudice grave, il faut obtenir une excellente adhérence entre l'empilement et le substrat et, partant, entre les diverses couches, combinée avec une bonne résistance à la rayure et à la corrosion.

Ces exigences s'appliquent d'autant plus au matériau bas indice constituant la couche supérieure ou extérieure de l'empilement, puisque qu'elle est en contact direct avec l'environnement externe.

Les polymères fluorés, en particulier les polymères et copolymères de tétrafluoroéthylène, sont bien connus pour leur faible indice de réfraction (généralement compris entre 1, 35 et 1,4 et, par exemple, égal à 1,35 à 630 nm pour le polytétrafluoroéthylène) ainsi que pour leur facilité de nettoyage, ce qui les rend particulièrement attrayants en tant que matériau pour la couche extérieure d'un empilement anti-reflets.

Dans "Optical multilayer films based on an amorphous fluoropolymer", J. Vac. Sci. Technol. A14 (1), 63, (1996*) 2 R. Chow*, *G. E. Loomis, R. L. Ward*", il est même fait état d'un indice de réfraction encore plus bas (1,29 à 630 nm) pour du Téflon^{®} AF(Téflon^{®} amorphe) déposé par évaporation sous vide, c'est-à-dire par une technique de dépôt physique en phase gazeuse (PVD) sous vide.

Dans le brevet US 5 882 773, il est décrit un procédé de réalisation d'un traitement antireflets sur un substrat optique comprenant le dépôt physique en phase gazeuse sous vide d'une couche à bas indice de réfraction entièrement constituée d'un polymère fluoré.

Cependant, les couches ainsi obtenues présentent l'inconvénient d'une mauvaise adhérence sur la plupart des matériaux.

Pour améliorer l'adhérence d'une couche à bas indice de réfraction à un substrat optique, le document EP 1 306 695 propose de former cette couche au moyen d'un procédé de dépôt assisté par faisceau d'ions.

Il n'en reste pas moins que la technique de dépôt par évaporation sous vide demeure la technique de choix à l'échelle industrielle, en raison notamment de sa facilité de mise en oeuvre, ainsi que de la reproductibilité et de l'uniformité des dépôts obtenus. Ceci est particulièrement vrai quand on la compare à d'autres techniques, telle que la technique de dépôt chimique en phase vapeur assistée par plasma (PECVD), qui est décrite par exemple dans la demande de brevet internationale WO 98/33077 et qui nécessite l'utilisation d'un équipement onéreux pour l'introduction contrôlée sous forme gazeuse de précurseurs de structure moléculaire complexe dans l'enceinte de traitement, lesquels sont, au demeurant, eux même généralement chers et souvent toxiques. En effet, les précurseurs généralement utilisés en PECVD sont liquides à température ambiante et doivent donc être chauffés à l'extérieur de l'enceinte de traitement.

La présente invention a, d'une manière générale, pour objet une disposition permettant d'assurer d'une manière simple l'adhérence d'une couche à bas indice de réfraction comprenant un polymère fluoré et déposée par évaporation sous vide, sur un substrat optique ou une couche sous jacente d'un empilement anti-reflets déposé sur ce substrat, et conduisant en outre à d'autres avantages.

De manière plus précise, la présente invention a pour objet un procédé de réalisation d'un traitement anti-reflets sur un substrat optique, comprenant l'étape de dépôt physique en phase gazeuse (PVD) sous vide d'une couche à bas indice de réfraction comprenant un polymère fluoré, caractérisé en ce que cette étape consiste à déposer une couche hybride silice (SiO₂) ou fluorure de magnésium (MgF₂) / polymère fluoré par évaporation simultanée sous vide de silice ou de fluorure de magnésium et d'un polymère fluoré.

Il en résulte une couche hybride de bas indice de réfraction, transparente dans le visible, qui non seulement adhère nettement mieux que le polymère fluoré pur évaporé sur un substrat optique ou une couche sous-jacente déposée préalablement sur ce substrat, mais présente également un bas indice de réfraction, intermédiaire entre le très bas indice de réfraction du polymère fluoré et le bas indice de réfraction de la silice (1,48 à 550 nm) ou du MgF₂ (1,38 à 550 nm), et donc particulièrement intéressant pour la réalisation de couches minces à bas indice de réfraction dans un empilement anti-reflets.

De plus, les propriétés de résistance à la rayure et à la corrosion demeurent tout à fait satisfaisantes.

Dans un premier mode de réalisation, on coévapore la silice ou le fluorure de magnésium et le polymère fluoré en sorte que ceux ci soient présents en proportions constantes sur toute l'épaisseur de la couche bas indice, ce qui permet d'obtenir une couche hybride de structure homogène et un indice constant sur toute l'épaisseur de la couche.

Dans un second mode de réalisation, on coévapore la silice ou le fluorure de magnésium et le polymère fluoré en faisant varier les proportions de façon contrôlée, ce qui permet d'obtenir une couche hybride à gradient d'indice sur tout ou partie de l'épaisseur de la couche.

De préférence également, la quantité de polymère fluoré dans la couche bas indice est maintenue à une valeur inférieure ou égale à environ 30 % en volume, le reste étant constitué de silice ou de fluorure de magnésium, car cela permet d'obtenir le meilleur compromis adhérence/indice de réfraction / résistance à l'abrasion.

Pour déposer ces composés selon les proportions choisies sur toute l'épaisseur de la couche bas indice, le procédé comporte, avantageusement, les étapes successives de mesure en continu de l'indice de réfraction de la couche bas indice en cours de formation ou des vitesses de dépôt respectives de la silice ou du fluorure de magnésium et du polymère fluoré ; de détermination des quantités respectives de silice ou de fluorure de magnésium et de polymère fluoré déposée à partir des résultats de ladite mesure ; et de régulation des paramètres de dépôts de la silice ou du fluorure de magnésium et/ou du polymère fluoré.

En pratique, les vitesses de dépôt peuvent être mesurées au moyen de microbalances à quartz et la concentration volumique de l'un des composés de la couche hybride peut être obtenu à partir de l'indice de réfraction en supposant une loi de Bruggeman linéarisée pour des mélanges des deux composés.

Pour des raisons d'optimisation des conditions de dépôt, la silice ou le fluorure de magnésium et le polymère fluoré sont évaporés par effet Joule ou au moyen d'un canon à électrons. En pratique, la silice ou le fluorure de magnésium est, de préférence, évaporé au moyen d'un canon à électrons et le polymère fluoré est évaporé par effet Joule.

Préférentiellement, le polymère fluoré est un polymère ou un copolymère de tétrafluoroéthylène, notamment un copolymère amorphe de 2,2-bistrifluorométhyl-4,5-difluoro-1,3-dioxole et de tétrafluoroéthylène.

A titre d'exemple, on peut utiliser le Teflon^{®} AF 1600 ou le Teflon^{®} AF 2400 commercialisés par la société Dupont de Nemours.

Le procédé suivant l'invention s'avère également particulièrement intéressant car il permet le dépôt de couches à bas indice de réfraction sur des substrats en matière organique.

Il s'avère, bien entendu, également particulièrement intéressant dans le cas où la couche bas indice est déposée en tant que couche extérieure d'un empilement anti-reflets déposée sur un substrat optique.

Suivant un mode de réalisation préféré, il consiste à fabriquer un empilement anti-reflets par les étapes successives de dépôt physique en phase gazeuse (PVD) sous vide de trois couches du type ZrO₂/SiO₂/ZrO₂, puis de dépôt de la couche bas indice extérieure.

En pratique, chaque étape de dépôt physique en phase gazeuse sous vide est, préférentiellement, effectuée à une pression inférieure ou égale à environ 10⁻² Pa.

L'invention porte également sur l'utilisation du procédé tel que défini supra pour améliorer l'adhérence d'une couche à bas indice de réfraction sur la couche sous-jacente d'un empilement anti-reflets déposée sur un substrat optique ou sur le substrat optique lui-même.

Elle concerne également un substrat optique, en particulier une lentille ophtalmique, susceptible d'être obtenu par le procédé selon l'invention et comportant une couche hybride silice ou fluorure de magnésium/polymère fluoré, comprenant le polymère fluoré en une quantité inférieure ou égale à environ 30 % en volume, le reste étant constitué de silice ou de fluorure de magnésium.

Les caractéristiques et avantages de l'invention ressortiront d'ailleurs de la description qui va suivre, à titre d'exemple, en référence aux dessins schématiques annexés sur lesquels :
la figure 1 est une représentation schématique de la configuration d'un dispositif de mise en oeuvre du procédé suivant l'invention ; et
- la figure 2 représente un empilement anti-reflets obtenu selon un mode de réalisation préféré de l'invention.

Dans la forme de réalisation représentée, le dispositif 10 de mise en oeuvre du procédé de réalisation de traitement anti-reflets selon l'invention se présente sous la forme d'une machine d'évaporation du type Leybold Heraeus 700 QE, constituée d'un bâti 11 définissant une chambre de dépôt 12.

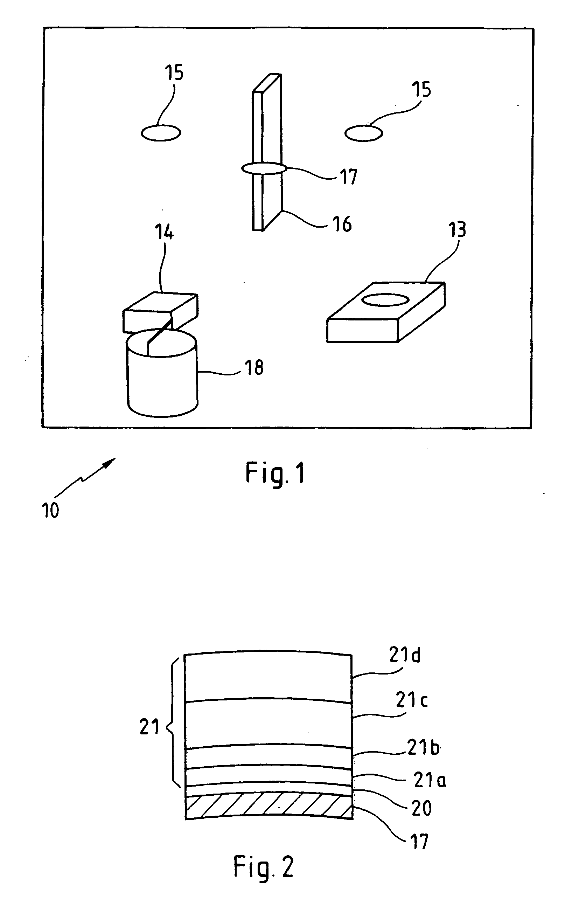

Un système de pompage (non représenté sur la figure 1 dans un souci de simplification) est également prévu pour faire le vide à l'intérieur de cette chambre de dépôt 12. Un piège froid (piège Meissner), qui n'a pas non plus été représenté sur la figure 1 dans un souci de simplification, est en outre disposé à l'intérieur de la machine 10 pour augmenter la vitesse de pompage de l'eau. Il est ainsi possible de descendre de la pression atmosphérique à la pression de traitement (en pratique de l'ordre de 10⁻² Pa) en quelques minutes.

La machine 10 est également équipée d'un canon à électrons 13 du type Leybold ESV 6 avec un creuset tournant à quatre cavités et d'une source d'évaporation à effet Joule 14.

Deux microbalances à quartz 15, séparées par un cache 16, servant à la mesure et l'asservissement des vitesses de dépôt. Elles sont, à cet effet, reliées par une boucle d'asservissement aux sources d'évaporation.

Pour maîtriser la composition d'une couche déposée on se base, ici, à cet égard, en première approximation sur le rapport des deux vitesses de dépôt affichées.

Un carrousel classique, qui n'a pas non plus été représenté dans un souci de simplification, fait office de porte-substrats à l'intérieur de la chambre 12.

Dans la forme de réalisation représentée, un seul substrat est visible et porte le repère numérique 17.

Un canon à ions 18, par exemple le canon à ions du type Mark Il commercialisé par COMMONWEALTH est par ailleurs également disposé à l'intérieur de cette chambre de dépôt 12 pour effectuer le nettoyage initial du substrat 17, préalablement au dépôt de la première couche mince anti-reflets.

Un exemple d'empilement pouvant être obtenu par le procédé selon l'invention est illustré à la figure 2.

Selon le mode de réalisation illustré à cette figure, un substrat organique 17 ici en CR39 revêtu d'un vernis anti-abrasion, disponible dans le commerce sous la dénomination ORMA SUPRA^{®} est revêtu d'un empilement anti-reflets 21 comprenant une alternance de couches minces à haut et bas indices de réfraction 21a - 21d.

Selon le mode de réalisation préféré illustré à la figure 2, la première couche 21a est en matériau à haut indice de réfraction, c'est-à-dire supérieure à 1,6. Ce matériau est ici composé d'oxyde de zirconium (ZrO₂) qui est déposé sur une épaisseur physique comprise typiquement entre 10 et 40 nm.

La seconde couche 21b déposée sur la première couche 21a est ici composée de silice (SiO₂), c'est-à-dire un matériau à bas indice de réfraction, et a une épaisseur typiquement comprise entre 10 et 55 nm.

La troisième couche 21c déposée est ici identique à la première couche 21a (couche de ZrO₂), sauf pour ce qui concerne l'épaisseur, qui est comprise entre 30 et 200 nm, et de préférence entre 120 et 150 nm.

Ces trois couches ont été déposées successivement par évaporation sous vide au moyen de la machine 10 illustrée à la figure 1.

Dans d'autres modes de réalisation, les matériaux constituant ces trois couches anti-reflets 21a-21c ainsi que ceux constituant le substrat 17 ou le vernis anti-abrasion 20, peuvent être remplacés par d'autres matériaux équivalents bien connus de l'homme du métier.

L'empilement anti-reflets 21 comporte en outre et conformément à l'invention une couche extérieure hybride 21d à bas indice de réfraction dont l'épaisseur est comprise entre 70 et 110 nm.

Suivant le mode de réalisation préféré, cette couche hybride est formée d'un mélange de silice (SiO₂) et d'un copolymère amorphe de 2,2-bistrifluorométhyl-4,5-difluoro-1,3-dioxole et de tétrafluoroéthylène, disponible dans le commerce sous la dénomination de Téflon^{®} AF 1600 ou de Téflon^{®} AF 2400. Ces copolymères fluorés amorphes sont solubles dans des solvants perfluorés et sa formule structurelle est la suivante (le rapport b:a, c'est-à-dire le rapport dioxole/tetrafluoroéthylène, est de 2 pour le AF 1600 et de 4,56 pour le AF 2400) :

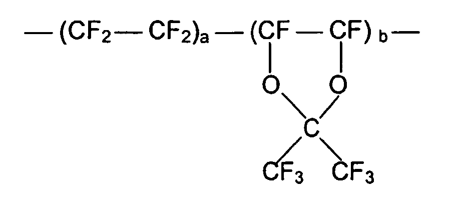

Ces composés ont été déposés par coévaporation sous vide (dépôt physique en phase gazeuse sous vide) à l'aide de la machine 10 illustrée à la figure 1, en sorte qu'ils soient présents en proportions constantes sur toute l'épaisseur de la couche bas indice 21d.

En pratique, la silice est évaporée au moyen du canon à électrons 13 et le copolymère amorphe est évaporé par effet Joule au moyen de la source d'évaporation par effet Joule 14.

Traditionnellement, sur un tel empilement anti-reflets est encore déposée une couche anti-salissures.

Dans le cas de la présente invention, le dépôt d'une telle couche n'est plus indispensable dans la mesure où la couche extérieure hybride assure déjà cette fonction anti-salissures.

Par ailleurs, la concentration volumique de copolymère fluoré amorphe dans la couche hybride 21d a été maintenue, suivant ce mode de réalisation préféré, à une valeur de l'ordre de 30 %.

Il convient de relever, à cet égard, que le Téflon^{®} AF 2400 a été liquéfié au moyen de la source d'évaporation à effet Joule 14 avant son évaporation au moyen de la même source.

Par ailleurs, comme cela a déjà été dit supra, la silice peut, dans d'autres modes de réalisation, être remplacée par du fluorure de magnésium (MgF₂), tandis que le copolymère fluoré amorphe précité peut notamment être remplacé par du polytétrafluoroéthylène. Dans un mode de réalisation préféré, ces copolymères fluorés amorphes peuvent être remplacés par du Téflon^{®} MP 1600 qui se présente sous la forme de microparticules d'une taille moyenne de 0,2 mm.

Dans un premier exemple, la couche hybride est issue de la coévaporation de silice et de polytétrafluoroéthylène (Téflon^{®} MP 1600), avec une proportion de Téflon^{®} constante égale à 30 %.

Le substrat 17 ainsi obtenu a été soumis au test Nx10 coups décrit dans la demande de brevet internationale WO 99/49097. Ce test sollicite l'adhésion des couches minces déposées sur un substrat organique. Il a révélé que l'empilement 21 présente de bonnes propriétés d'adhérence et, en particulier, que la couche hybride 21d adhérait d'une manière tout à fait satisfaisante à la couche sous-jacente de ZrO₂.

Le substrat 17 a également été soumis au test appelé test "paille de fer", d'après lequel on réalise cinq allers-retours avec une paille de fer extra fine sur un substrat revêtu afin d'apprécier la résistance à la rayure de celui-ci. Ce test a également révélé que l'empilement anti-reflets 21 présentait une résistance tout à fait satisfaisante à la rayure. En outre, la mesure de l'indice de réfraction de la couche hybride a révélé une valeur très intéressante de 1,42 pour une longueur d'ondes de 630 nm. On appréciera également que la couche hybride 21d obtenue au moyen du procédé selon l'invention présente une structure homogène, d'indice de réfraction constant sur toute son épaisseur, et est parfaitement transparente dans le visible.

Dans un deuxième exemple, en maîtrisant les vitesses de dépôt, on obtient une couche hybride dont l'indice varie de façon linéaire de 1,46 à 1,33 en allant du substrat vers la surface, correspondant à des proportions volumiques de Téflon^{®} allant de zéro à environ 80 %.

Plus généralement, il s'est avéré que le procédé selon l'invention permet d'obtenir des empilements anti-reflets ayant des couches minces présentant des caractéristiques très satisfaisantes du point de vue de l'adhérence, de la résistance aux rayures, de la résistance à la corrosion et de la facilité de nettoyage.

Bien entendu, la présente invention ne se limite pas à la forme de réalisation décrite et représentée, mais englobe toute variante d'exécution.

## Revendications

1. Procédé de réalisation d'un traitement anti-reflets sur un substrat optique, comprenant l'étape de dépôt physique en phase gazeuse (PVD) sous vide d'une couche à bas indice de réfraction comprenant un polymère fluoré, **caractérisé en ce que** cette étape consiste à déposer une couche hybride silice (SiO₂) ou fluorure de magnésium (MgF₂) / polymère fluoré par évaporation simultanée sous vide de silice ou de fluorure de magnésium et d'un polymère fluoré.

2. Procédé selon la revendication 1, **caractérisé en ce qu'**il consiste à coévaporer la silice ou le fluorure de magnésium et le polymère fluoré en sorte que ceux-ci soient présents en proportions constantes sur toute l'épaisseur de la couche bas indice.

3. Procédé selon la revendication 2, **caractérisé en ce que** la quantité de polymère fluoré dans la couche bas indice est maintenue à une valeur inférieure ou égale à environ 30 % en volume, le reste étant constitué de silice ou de fluorure de magnésium.

4. Procédé selon la revendication 1, **caractérisé en ce qu'**il consiste à coévaporer la silice ou le fluorure de magnésium et le polymère fluoré en faisant varier leurs proportions de façon contrôlée sur tout ou partie de l'épaisseur de la couche bas indice.

5. Procédé selon la revendication 4, **caractérisé en ce que** la quantité de polymère fluoré dans la couche bas indice va de zéro à environ 80 % en volume en allant du substrat vers la surface de cette couche, le reste étant constitué de silice ou de fluorure de magnésium.

6. Procédé selon l'une quelconque des revendications 2 à 5, **caractérisé en ce qu'**il comporte les étapes successives de mesure en continu de l'indice de réfraction de la couche bas indice en cours de formation ou des vitesses de dépôt respectives de la silice ou du fluorure de magnésium et du polymère fluoré; de détermination des quantités respectives de silice ou de fluorure de magnésium et de polymère fluoré déposées à partir des résultats de ladite mesure ; et de régulation des paramètres de dépôt de la silice ou du fluorure de magnésium et/ou du polymère fluoré en vue de déposer ceux-ci selon des proportions choisies sur toute l'épaisseur de la couche bas indice.

7. Procédé selon l'une quelconque des revendications 1 à 6, **caractérisé en ce que** la silice ou le fluorure de magnésium et le polymère fluoré sont évaporés par effet Joule ou au moyen d'un canon à électrons.

8. Procédé selon la revendication 7, **caractérisé en ce que** la silice ou le fluorure de magnésium est évaporée au moyen d'un canon à électrons et le polymère fluoré est évaporé par effet Joule.

9. Procédé selon l'une quelconque des revendications 1 à 8, **caractérisé en ce que** le polymère fluoré est un polymère ou un copolymère de tétrafluoroéthylène.

10. Procédé selon la revendication 9, **caractérisé en ce que** le copolymère de tétrafluoroéthylène est un copolymère amorphe de 2,2-bistrifluorométhyl-4,5-difluoro-1,3-dioxole et de tétrafluoroéthylène.

11. Procédé selon l'une quelconque des revendications 1 à 10, **caractérisé en ce que** le substrat est un substrat en matière organique.

12. Procédé selon l'une quelconque des revendications 1 à 11, **caractérisé en ce que** la couche bas indice est déposée en tant que couche extérieure d'un empilement anti-reflets déposé sur le substrat optique.

13. Procédé selon la revendication 12, **caractérisé en ce qu'**il consiste à fabriquer un empilement anti-reflets par les étapes successives de dépôt physique en phase gazeuse (PVD) sous vide de trois couches du type ZrO₂/SiO₂/ZrO₂, puis de dépôt de la couche bas indice extérieure.

14. Procédé selon la revendication 13, **caractérisé en ce que** chaque étape de dépôt physique en phase gazeuse sous vide est effectuée à une pression inférieure ou égale à environ 10⁻² Pa.

15. Utilisation du procédé selon l'une quelconque des revendications 1 à 14 pour améliorer l'adhérence d'une couche à bas indice de réfraction sur la couche sous-jacente d'un empilement anti-reflets déposé sur un substrat optique ou sur le substrat optique lui-même.

16. Substrat optique (17), en particulier une lentille ophtalmique, susceptible d'être obtenu par le procédé selon l'une quelconque des revendications 1 à 12 et qui comporte une couche hybride (21d) à bas indice de réfraction silice ou fluorure de magnésium polymère fluoré, comprenant le polymère fluoré en une quantité inférieure ou égale à environ 30 % en volume, le reste étant constitué de silice ou de fluorure de magnésium.

17. Substrat optique selon la revendication 16, **caractérisé en ce que** les proportions respectives de silice ou de fluorure de magnésium et de polymère fluoré sont constantes sur toute l'épaisseur de la couche bas indice.

18. Substrat optique selon la revendication 16 ou 17, **caractérisé en ce que** le polymère fluoré est un polymère ou un copolymère de tétrafluoroéthylène.

19. Substrat optique selon l'une des revendications 16 à 18, **caractérisé en ce qu'**il est composé d'une matière organique.

20. Substrat optique selon l'une quelconque des revendications 16 à 19, **caractérisé en ce que** la couche bas indice est une couche extérieure hybride sur un empilement de trois couches anti-reflets (21a-21c) du type ZrO₂/SiO₂/ZrO₂.

## Claims

1. Method for applying an antireflection treatment to an optical substrate including a step of physical vapour-phase deposition (PVD) in a vacuum of a layer having a low refractive index and including a fluorinated polymer and **characterised in that** said step consists in depositing a hybrid silica (SiO₂) or magnesium fluoride (MgF₂)/fluorinated polymer layer by simultaneous evaporation in a vacuum of silica or magnesium fluoride and a fluorinated polymer.

2. Method according to claim 1, **characterised in that** it consists in co-evaporating the silica or magnesium fluoride and fluorinated polymer so that they are present in constant proportions throughout the thickness of the low index layer.

3. Method according to claim 2, **characterised in that** the quantity of fluorinated polymer in the low index layer is kept less than or equal to approximately 30% by volume, the remainder consisting of silica or magnesium fluoride.

4. Method according to claim 1, **characterised in that**, when co-evaporating the silica or magnesium fluoride and fluorinated polymer, their proportions are allowed to vary in a controlled manner over the whole of or a portion of the thickness of the low index layer.

5. Method according to claim 4, **characterised in that** the quantity of fluorinated polymer in the low index layer is from zero to approximately 80% by volume in the direction from the substrate toward the surface of this layer, the remainder consisting of silica or magnesium fluoride.

6. Method according to any one of claims 2 to 5, **characterised in that** it includes the successive steps of continuously measuring the refractive index of the low index layer being formed or the respective rates of deposition of the silica or magnesium fluoride and fluorinated polymer, determining from said measurements the respective quantities of silica or magnesium fluoride and fluorinated polymer deposited, and regulating the silica or magnesium fluoride and/or fluorinated polymer deposition parameters in order to deposit them in selected proportions throughout the thickness of the low index layer.

7. Method according to any one of claims 1 to 6, **characterised in that** the silica or magnesium fluoride and fluorinated polymer are evaporated by means of the Joule effect or by means of an electron gun.

8. Method according to claim 7, **characterised in that** the silica or magnesium fluoride is evaporated by means of an electron gun and the fluorinated polymer is evaporated by means of the Joule effect.

9. Method according to any one of claims 1 to 8, **characterised in that** the fluorinated polymer is a polymer or a copolymer of tetrafluoroethylene.

10. Method according to claim 9, **characterised in that** the copolymer of tetrafluoroethylene is an amorphous copolymer of 2,2-bistrifluoromethyl-4,5-difluoro-1,3-dioxole and tetrafluoroethylene.

11. Method according to any one of claims 1 to 10, **characterised in that** the substrate is an organic material substrate.

12. Method according to any one of claims 1 to 11, **characterised in that** the low index layer is the outside layer of an antireflection multilayer film deposited on the optical substrate.

13. Method according to claim 12, **characterised in that** it consists in fabricating an antireflection multilayer film by the successive steps of physical vapour-phase deposition (PVD) in a vacuum of three layers of the type ZrO₂/SiO₂/ZrO₂ and then depositing the low index outside layer.

14. Method according to claim 13, **characterised in that** each step of physical vapour-phase deposition in a vacuum is effected at a pressure less than or equal to approximately 10⁻² Pa.

15. Use of the method according to any one of claims 1 to 14 to improve the adhesion of a low refractive index layer to the underlying layer of an antireflection multilayer film deposited on an optical substrate or to the optical substrate itself.

16. Optical substrate (17), in particular an ophthalmic lens, likely to be obtained by the method according to any one of claims 1 to 12 and that includes a low refractive index hybrid layer (21d) of silica or magnesium fluoride/fluorinated polymer containing the fluorinated polymer in an amount less than or equal to approximately 30% by volume, the remainder consisting of silica or magnesium fluoride.

17. Optical substrate according to claim 16, **characterised in that** the respective proportions of silica or magnesium fluoride and fluorinated polymer are constant throughout the thickness of the low index layer.

18. Optical substrate according to claim 16 or claim 17, **characterised in that** the fluorinated polymer is a polymer or a copolymer of tetrafluoroethylene.

19. Optical substrate according to any one of claims 16 to 18, **characterised in that** it consists of an organic material.

20. Optical substrate according to any one of claims 16 to 19, **characterised in that** the low index layer is a hybrid outside layer on a multilayer film of three antireflection layers (21a-21c) of the ZrO₂/SiO₂/ZrO₂ type.

## Patentansprüche

1. Verfahren zur Ausbildung einer Entspiegelungsbehandlung an einem optischen Substrat, umfassend den Schritt des physischen Vakuumfällens in Gasphase (PVD), einer Schicht mit niedrigem Brechungsindex, umfassend ein fluoriertes Polymer, **dadurch gekennzeichnet, dass** dieser Schritt darin besteht, eine Hybridschicht zu fällen aus Siliziumdioxyd (SI02) oder Magnesiumfluorid (MGF2)/ fluoriertes Polymer mittels gleichzeitiger Verdampfung in Vakuum von Siliziumdioxyd oder Magnesiumfluorid und von fluoriertem Polymer.

2. Verfahren nach Anspruch 1, **dadurch gekennzeichnet, dass** es darin besteht das Siliziumdioxyd oder das Magnesiumfluorid und das fluorierte Polymer gemeinsam derart zu verdampfen, dass diese bei konstantem Anteilen bezüglich der gesamten Dicke der Schicht mit niederem Index vorliegen.

3. Verfahren nach Anspruch 2, **dadurch gekennzeichnet, dass** die Menge an fluoriertem Polymer in der Schicht niederem Index beibehalten wird bei einem Wert von weniger oder gleich zu etwa 30 Volumenprozent, wobei der Rest gebildet ist aus Siliziumdioxyd oder aus Magnesiumfluorid.

4. Verfahren nach Anspruch 1, **dadurch gekennzeichnet, dass** es darin besteht das Siliziumdioxyd oder das Magnesiumfluorid und das fluorierte Polymer gemeinsam zu verdampfen, indem deren Anteile in gesteuerter Art und Weise bezüglich einem Teil oder der Gesamtheit der Dicke der Schicht mit niederem Index verändert wird.

5. Verfahren nach Anspruch 4, **dadurch gekennzeichnet, dass** die Menge an fluorierte Polymer in der Schicht mit niederem Index von 0 bis etwa 80 Volumenprozent ausmacht, verlaufend von dem Substrat hin zur Oberfläche der Schicht, wobei der Rest gebildet ist aus Siliziumdioxyd oder Magnesiumfluorid.

6. Verfahren nach einem der Ansprüche 2 bis 5, **dadurch gekennzeichnet, dass** es die sukzessiven Schritte umfasst des kontinuierlichen Messens des Brechungsindex der sich bildenden Schicht mit niederem Index oder der jeweiligen Fällungs- bzw. Niederschlagsgeschwindigkeiten des Siliziumdioxyds oder des Magnesiumfluorids und des fluorierten Polymers, der Bestimmung der jeweiligen Mengen an gefälltem bzw. niedergeschlagenem Siliziumdioxyd oder Magnesiumfluorid und fluoriertem Polymer, ausgehend von den Ergebnissen der Messung; und der Regulierung der Fällungs- oder Niederschlagsparameter des Siliziumdioxyds oder des Magnesiumfluorids und/ oder des fluorierten Polymers in Anbetracht des Niederschlages bzw. der Fällung davon entsprechend der gewählten Proportionen bzw. Anteile über die gesamte Dicke der Schicht mit niederem Index.

7. Verfahren nach einem der Ansprüche 1 bis 6, **dadurch gekennzeichnet, dass** das Siliziumdioxyd oder das Magnesiumfluorid und das fluorierte Polymer mittels Jouleschem Effekt oder mittels einer Elektronenkanone verdampft werden.

8. Verfahren nach Anspruch 7, **dadurch gekennzeichnet, dass** das Siliziumdioxyd oder das Magnesiumfluorid verdampft wird mittels einer Elektronenkanone, wobei das fluorierte Polymer verdampft wird mittels Jouleschem Effekt.

9. Verfahren nach einem der Ansprüche 1 bis 8, **dadurch gekennzeichnet, dass** das fluorierte Polymer bzw. Fluor-Polymer ein Polytetrafluorethylenpolymer oder -copolymer ist.

10. Verfahren nach Anspruch 9, **dadurch gekennzeichnet, dass** das Tetrafluorethylencopolymer ein amorphes Copolymer von 2,2 bis Trifluormethyl-4,5-difluoro-1,3-Dioxol und von Tetrafluorethylen ist.

11. Verfahren nach einem der Ansprüche 1 bis 10, **dadurch gekennzeichnet, dass** das Substrat ein Substrat aus organischem Material ist.

12. Verfahren nach einem der Ansprüche 1 bis 11, **dadurch gekennzeichnet, dass** die Schicht mit niederem Index gefällt oder niedergeschlagen wird als äußere Schicht eines Anti-Reflex- bzw. Entspiegelungsschichtstapels, gefällt bzw. niedergeschlagen an dem optischen Substrat.

13. Verfahren nach Anspruch 12, **dadurch gekennzeichnet, dass** es darin besteht einen Anti-Reflex bzw. Entpiegelungsschichtstapel herzustellen mittels sukzessiver Schritte des physischen Vakuumfällens in Gasphase (PVD) von 3 Schichten von ZrO₂/SiO₂/ZrO₂, mit anschließender Fällung der äußeren Schicht mit niederem Index.

14. Verfahren nach Anspruch 13, **dadurch gekennzeichnet, dass** jeder Schritt des physischen Vakuumfällens in Gasphase durchgeführt wird, bei einem Druck von weniger oder gleich zu etwa 10⁻² Pascal.

15. Verwendung des Verfahrens nach einem der Ansprüche 1 bis 14 zum Verbessern der Adhäsion einer Schicht mit niederem Brechnungsindex bezüglich der darunterliegenden Schicht eines Anti-Reflex- bzw. Entspiegelungsschichtstapels, gefällt oder niedergeschlagen an einem optischen Substrat, oder bezüglich dem optischen Substrat selbst.

16. Optisches Substrat (17), insbesondere eine ophthalmische Linse, geeignet erhalten zu werden mittels des Verfahrens nach einem der Ansprüche 1 bis 12, und welches eine hybride Schicht (21d) mit niederem Brechungsindex aufweist, aus Siliziumdioxyd oder Magnesiumfluorid/ fluoriertem Polymer, umfassend das fluorierte Polymer bei einer Menge, die geringer oder gleich ist zu etwa 30 Volumenprozent, wobei der Rest gebildet ist aus Siliziumdioxyd oder Magnesiumfluorid.

17. Optisches Substrat nach Anspruch 16, **dadurch gekennzeichnet, dass** die jeweiligen Anteile oder Proportionen an Siliziumdioxyd oder Magnesiumfluorid und an fluoriertem Polymer konstant sind bezüglich der gesamten Dicke der Schichten mit niederem Index.

18. Optisches Substrat nach Anspruch 16 oder 17, **dadurch gekennzeichnet, dass** das fluorierte Polymer bzw. Fluor-Polymer ein Tetrafluorethylenpolymer oder -copolymer ist.

19. Optisches Substrat nach einem der Ansprüche 16 bis 18, **dadurch gekennzeichnet, dass** es gebildet ist aus einem organischem Material.

20. Optisches Substrat nach einem der Ansprüche 16 bis 19, **dadurch gekennzeichnet, dass** die Schicht mit niederem Index eine äußere Hybridschicht in einem Schichtstapel von 3 Antireflektions- bzw. Entspiegelungsschichten (21a- 21c) vom Typ ZrO₂/SiO₂/ZrO₂ ist.
